# EUROPEAN PATENT SPECIFICATION

(11) **EP 1 367 331 B1**
(45) Date of publication and mention of the grant of the patent: **15.02.2006**
(21) Application number: 03101460.8
(22) Date of filing: 21.05.2003
(51) Int. Cl.: F24F 1/02, H05K 7/20

(54) **Compact air-cooling device for a closed technical cabinet**
Kompaktklimagerät für einen Schaltschrank
Appareil compact de climatisation pour une armoire de distribution

(30) Priority: 28.05.2002 LU 90926
(43) Date of publication of application: 03.12.2003
(73) Proprietor: Uniflair Industries S.P.A., 35026 Conselve (IT)
(72) Inventor: Catzel, Pincus, 7806, Constantia, Cape Town (ZA)
(74) Representative: Schmitt, Armand

(56) References cited:
- EP-A- 0 055 000
- WO-A-93/18351
- DE-A- 4 343 610
- DE-A- 4 343 611
- GB-A- 2 251 064
- GB-A- 2 300 910
- US-A- 2 283 928
- US-A- 3 366 169
- US-A- 4 478 053
- US-A- 4 562 955
- US-A- 6 164 369
- PATENT ABSTRACTS OF JAPAN vol. 1997, no. 06, 30 June 1997 (1997-06-30) -& JP 09 033066 A (HITACHI LTD), 7 February 1997 (1997-02-07)
- PATENT ABSTRACTS OF JAPAN vol. 2002, no. 03, 3 April 2002 (2002-04-03) -& JP 2001 324170 A (MITSUBISHI HEAVY IND LTD), 22 November 2001 (2001-11-22)

## Description

### Field of the invention

The present invention relates to a compact air-cooling device for a closed technical cabinet containing heat generating equipment, as e.g. electrical switch and control gear and telecommunication equipment.

### Background of the invention

More and more of such closed technical cabinets need forced air-cooling during the whole year, to warrant that the temperature within the cabinet does not exceed the maximum temperature imposed by the equipment manufacturers.

Simple forced air-cooling systems for closed technical cabinets use a fan to extract hot air from the closed technical cabinet. The hot air within the cabinet is simply replaced with air from the outside environment of the cabinet, which enters into the cabinet through ventilation openings. A major disadvantage of these simple ventilation systems is that in summer the outside environment of the cabinet may be too hot to warrant that a maximum temperature limit is not exceeded within the cabinet. Their advantages are of course the simplicity of the equipment (only a fan and a thermostat are required) and low electric power consumption. Furthermore, due to a low electric power draw, the forced air-cooling systems may be easily powered by an emergency power supply in case of power failure of the main electric supply.

If a closer temperature control within the cabinet is required, it is known to fit a compact mechanical air-cooling unit within a wall element of the cabinet to be cooled (see for example GB-A-2251064). Such a compact mechanical air-cooling unit includes a mechanical refrigeration unit with a compressor, an evaporator arranged in a primary air circuit and a condenser arranged in a secondary air circuit. A primary fan circulates the cabinet air in a closed loop through the primary air circuit, wherein the cabinet air is cooled in the evaporator. A secondary fan circulates air from the outside environment of the cabinet through a separate secondary air circuit, wherein it cools the condenser. A major disadvantage of such a mechanical refrigeration system is a rather high electric power consumption over the year. Furthermore, due to the high power draw of the refrigeration compressor, which has usually one single stage, the mechanical air-cooling unit is usually not connected to an emergency power supply and there is consequently no cooling of the cabinet in the event of a power failure.

### Object of the invention

The technical problem underlying the present invention is to provide an air-cooling device for a closed technical cabinet containing heat generating equipment, wherein said compact air-cooling device shall be compact enough to be easily integrated in the body of the cabinet, shall be able to warrant a close temperature control within the cabinet during the whole year, shall allow an optimization of energy consumption and shall have a reduced power draw in case of emergency power supply. This problem is solved by a compact air-cooling device as claimed in claim 1. Preferred embodiments of the claimed solution are defined in the dependant claims.

### Summary of the invention

A compact air-cooling device in accordance with the present invention comprises a housing, a mechanical refrigeration unit including an evaporator and an condenser mounted in the housing, as well as primary fan means and secondary fan means mounted in the housing for circulating air through the evaporator and the condenser. Partition elements are mounted in the housing for defining therein a primary air circuit and a separate secondary air circuit. The primary air circuit is designed so that the primary fan means takes in air through an inside air intake chamber, which is in direct communication with the inside of the closed technical cabinet, sucks it through the evaporator and blows it back into the inside of the closed technical cabinet, so as to provide a mechanical cooling in a closed loop with air from the inside of the closed technical cabinet. The secondary air circuit is designed so that the secondary fan means takes in air from the outside environment of the closed technical cabinet and blows it through the condenser back into the outside environment of the closed technical cabinet, so as to cool the condenser with air from the outside environment of the closed technical cabinet. In accordance with an important aspect of the present invention, the aforementioned partition elements include movable elements which can be brought into an auxiliary position in which the secondary air circuit is in communication with the primary air circuit upstream of the evaporator, and the inside air intake chamber is sealed off from the primary air circuit and is in direct communication with the outside environment of the closed technical cabinet.

It will be appreciated that with a compact air cooling device in accordance with the present invention three modes of operation are possible for cooling the cabinet. The first mode of operation consists in a mechanical cooling with air from the inside of the closed technical cabinet circulated in closed loop through the primary air circuit. In this first mode, the device operates just in the same way as the afore-described compact mechanical air-cooling units for technical cabinets. The second mode of operation consists in a mechanical cooling in an open loop with air from the outside environment of the closed technical cabinet, wherein air from the inside of the closed technical cabinet is evacuated by overpressure through the inside air intake chamber directly into the outside environment of the closed technical cabinet. This mode of operation allows to save refrigeration energy and to warrant nevertheless a close temperature control if the "outside air" is colder than the "inside air" but not cold enough to warrant free cooling of the cabinet. The third mode of operation consists in a free cooling of the closed technical cabinet with air from the outside environment of the closed technical cabinet that is not subjected to a mechanical refrigeration. In conclusion, a compact device in accordance with the present invention warrants, during the whole year, a close control of the temperature inside the closed technical cabinet, while simultaneously allowing an optimization of energy consumption by switching between its three modes of operation in function of the thermodynamic air conditions in the outside and inside environments of the closed technical cabinet. Furthermore, if a device in accordance with the present invention has to be powered by an electric emergency supply, the device can be set to operate in the free cooling mode, wherein the electric energy supply for the cooling unit and the secondary fan means is interrupted, so that the device has a considerably reduced power draw in case of emergency power supply. Last but not least, it will be appreciated that the overall dimensions of the housing of a device in accordance with the present invention, which allows three modes of operation, can be substantially of the same size as those of a compact mechanical air-cooling unit that allows only mechanical cooling in a closed loop with air from the inside of the closed technical cabinet.

In a preferred embodiment, the compact housing has a front side, a rear side, an upper side, a lower side and two lateral sides and is designed to be mounted on or in an enclosure element of the closed technical cabinet, so that its front side is in direct communication with the outside environment of the closed technical cabinet. This preferred embodiment can be particularly compact if the condenser is mounted in an opening in the front side of the housing, so that its upper edge is located close to the upper side of the housing, if the evaporator is mounted obliquely in the housing, wherein its lower edge is located substantially in the middle of the housing and its upper edge is located in a corner of the housing where the rear side joins the upper side of the housing, and if the partition elements include a fixed partition wall extending from the lower edge of the evaporator to the upper edge of the condenser, so as to separate a condenser inlet chamber from an evaporator outlet chamber.

In a preferred embodiment, the partition elements define an outside air i n-take chamber in which the secondary fan means is located and which is in direct communication with the condenser inlet chamber. The movable partition elements advantageously include a damper that is movable between a first position, in which it seals off the outside air intake chamber from the primary air circuit, and a second position, in which it establishes a direct communication between the outside air intake chamber and the primary air circuit upstream of the evaporator and simultaneously seals off the inside air intake chamber from the primary air circuit. In a preferred embodiment, the movable partition elements further include a damper capable of opening and closing a communication between the inside air intake chamber and an inside air outlet opening in the housing that opens into the outside environment of the closed technical cabinet.

### Brief description of the drawings

The present invention will now be described, by way of example, with reference to the accompanying drawings, in which:
- Fig. 1:: is a schematic section through an air-cooling device in accordance with the invention, illustrating mechanical cooling in a closed loop with re-circulated air from the inside of the cabinet;
- Fig. 2:: is a schematic section through the air-cooling device of Fig. 1, illustrating mechanical cooling with air from the outside environment of the cabinet; and
- Fig. 3:: is a schematic section through the air-cooling device of Fig. 1, illustrating free cooling with air from the outside environment of the cabinet.

### Detailed description of a preferred embodiment

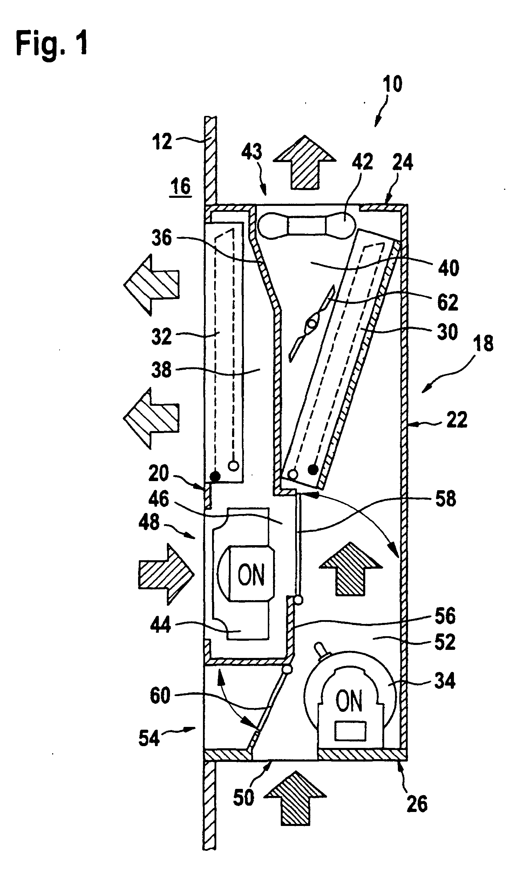

Fig. 1 to 3 show a schematic section through an air-cooling device 10 for a closed technical cabinet containing heat generating equipment, such as e.g. electrical switch and control gear and active telecommunication equipment. This closed technical cabinet is schematically represented by an element 12 of its enclosure, wherein the inside of the cabinet is globally identified with reference number 14 and its outside environment is globally identified with reference number 16.

The air-cooling device 10 comprises a prismatic housing 18 that is mounted in an opening of the enclosure element 12. It has a front side 20, a rear side 22, an upper side 24, a lower side 26 and two lateral sides. The front side 20 is in direct communication with the outside environment 16 of the closed technical cabinet. All the other sides of the housing 18 are located within the inside 14 of the closed technical cabinet. It remains to be pointed out that the enclosure element 12 is advantageously a hinged door element of the closed technical cabinet, so that the air-cooling device 10 is easily accessible for maintenance by simply opening the hinged door element 12. Furthermore, it will be noted that the overall dimensions of the prismatic housing 18 must be rather small, so that as to take a minimum of space within the cabinet. Typical overall dimensions for the housing 18 are e.g.: a height of about 750 mm, a depth of about 250 mm and a width (that is the dimension perpendicular to the plane of the figures) of about 300 mm.

In the housing 18 is mounted a mechanical refrigeration unit comprising an evaporator 30, a condenser 32 and a compressor 34. The condenser 32 is mounted in an opening in the front side 20 of the housing so that it is in direct communication with the outside environment 16 of the closed technical cabinet. Its upper edge is located close to the upper side 24 of the housing 18. Its lower edge is located at about half the height of the front side 20. The evaporator 30 is mounted obliquely within the housing 18, wherein its lower edge is located substantially in the middle of the housing 18 and its upper edge is located in a corner of the housing where the rear side 22 joins said upper side 24 of the housing 18. A fixed partition wall 36 extends from the lower edge of the evaporator 30 to the upper edge of the condenser 32, so as to separate within the housing 18 a condenser inlet chamber 38 from an evaporator outlet chamber 40. It will be appreciated that-due to the aforementioned design-both the evaporator 30 and the condenser 32 may have a rather big heat exchange surface with a rather small pressure drop, which results of course in a high energy efficiency.

The air-cooling device 10 further comprises primary fan means and secondary fan means mounted in the housing 18 for circulating air through the evaporator 20 and the condenser 22. The primary fan means advantageously comprises one or more axial fans 42 mounted in a supply air outlet opening 43 of the upper side 24 of the housing 18. The secondary fan means advantageously comprises a radial fan 44 mounted in an outside air intake chamber 46 of the housing 18, so as to be able take in air from the outside environment 16 through an outside air inlet opening 48, which is arranged in the front side 20 of the housing 18 just below the condenser 32. An inside air inlet opening 50 is provided in the lower side 26 of the housing 18 (or alternatively in the lower part of the rear side 22 or the lateral sides). This inside air inlet opening 50 opens into an inside air intake chamber 52 of the housing 18, in which the compressor 34 is advantageously arranged. An inside air outlet opening 54 is provided in the front side 20 of the housing 18, near the lower edge of the latter.

It will also be noted that air-cooling device 10 further includes an air filter 39 that is arranged upstream of the evaporator 30, where it extends obliquely upwards from the lower edge of the partition wall 36 to the rear side 22 over substantially the whole width of the housing 18. It will be appreciated that this air filter 39 may be easily exchanged from the rear side 22 of the housing 18. Furthermore, because of its rather big filter surface, it achieves a rather good filtering efficiency with a small pressure drop.

In the mode of operation illustrated in Fig. 1 (i.e, mechanical cooling in a closed loop), the aforementioned fixed partition wall 36 and further fixed and movable partition elements 56, 58, 60 cooperate to delimit within the housing 18 a primary air circuit and a secondary air circuit. In the primary air circuit, the primary fan means 42 takes in air from the inside 14 through the air inlet opening 50 of the inside air intake chamber 50, sucks it through the evaporator 30 into the evaporator outlet chamber 40 and blows it back into the inside 14 of the closed technical cabinet. In the secondary air circuit, the secondary fan means 44 takes in air from the outside environment 16 into the outside air intake chamber 46. From the latter the air flows into the condenser inlet chamber 38, to leave the housing 18 through the condenser 32 into the outside environment 16. It will be noted that in this mode of operation there is no significant air exchange between the primary air circuit and the secondary air circuit. The cabinet air is re-circulated through the primary air circuit and cooled therein by the refrigerant evaporating in the evaporator 30, whereas the outside air is circulated through the secondary air circuit to condense the refrigerant in the condenser 32.

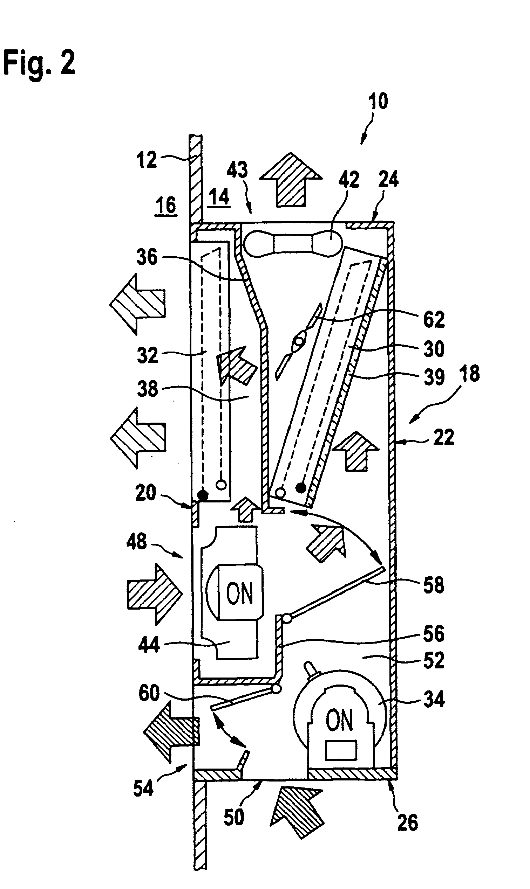

Referring now simultaneously at Fig. 1 and 2, it will be noted that the movable partition element identified by reference number 58 is conceived as a first damper that is movable between a first position, in which it seals off the outside air intake chamber 46 from the primary air circuit (see Fig. 1), and a second position, in which it establishes a direct communication between the outside air intake chamber 46 and the primary air circuit upstream of the evaporator 30 and simultaneously seals off the inside air intake chamber 52 from the primary air circuit (see Fig. 2). The movable partition element identified by reference number 60 is conceived as a second damper that is movable between a first position, in which it seals off the inside air intake chamber 52 from the inside air outlet opening 54 (see Fig. 1), and a second position, in which it establishes a direct communication between the inside air intake chamber 52 and the inside air outlet opening 54 (see Fig. 2).

In the mode of operation illustrated in Fig. 2, the outside air taken in by the secondary fan means 44 divides itself into two streams. A first stream passes through the condenser 32 (wherein it condenses the refrigerant) back into the outside environment 16. A second stream passes through the evaporator 30 (wherein it is cooled by evaporation of the refrigerant) into the evaporator outlet chamber 40 and is blown by the primary fan means 42 into the closed technical cabinet. Surplus air leaves the closed technical cabinet by overpressure, passing through the inside air intake chamber 52, the open damper 60 and the inside air outlet opening 54 into the outside environment 16. Mechanical cooling with outside air, as illustrated in Fig. 2, is of advantage if the thermodynamic conditions of the outside air are, with regard to energy consumption of the mechanical cooling unit, more favorable than the thermodynamic conditions of the re-circulated inside air.

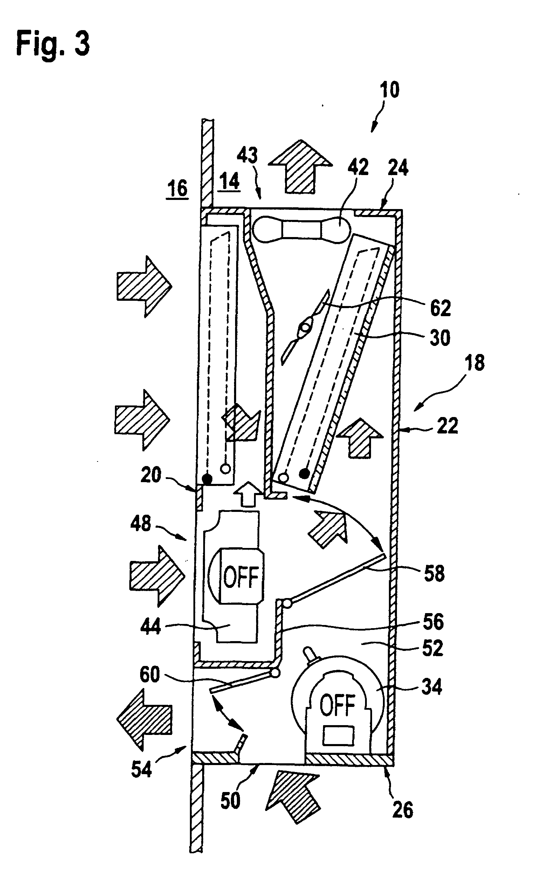

In the mode of operation illustrated in Fig. 3, the dampers 58 and 60 are in the same position as in Fig. 2. However, the secondary fan means 44 is shut off, as well as the compressor 34. The primary fan means 42 now sucks outside air through the outside air inlet opening 48 and the condenser 32 and blows it, without any further mechanical refrigeration of the outside air, into the closed cabinet. This mode of operation is applied if the thermodynamic conditions of the outside air allow a free cooling of the closed technical cabinet. Due to the particular design of airflow path in the air-cooling device 10, only a small overpressure will establish in the cabinet during free cooling. This allows to warrant a high airflow and energy efficiency for the free cooling operation mode.

The compact air-cooling device 10 of the present invention may further include an electrical heating element 60. The latter is advantageously arranged in the evaporator outlet chamber 40 and is capable of reheating the supply air, e.g. in case of free cooling with very cold outside air.

The switching between the three modes of operation is advantageously govemed by control means (not shown). This control means measures the thermodynamic conditions (temperature, humidity) of the air outside and inside the closed technical cabinet and sets the dampers 58, 60 either in the position of Fig. 1 or Fig. 2 depending on these thermodynamic conditions. Furthermore, if the thermodynamic conditions of the outside air allow a free cooling of the closed technical cabinet, the control means shuts off the secondary fan means 44, as well as the compressor 34, with the dampers 58, 60 set in the position illustrated in Fig. 2.

The compact air-cooling device 10 of the present invention is advantageously connected to a main electric supply and to an electric emergency supply. When, in case of a power failure of the main electric supply, the device has to be powered by the electric emergency supply, control means automatically set the dampers 58, 60 in the position illustrated in Fig. 2, and the electric energy supply for the compressor 34 of the cooling unit and the secondary fan means 44 is interrupted. In a preferred embodiment the primary fan means 42 and the control means of the dampers 58, 60 are e.g. powered via a 48 V DC power supply with battery back-up, and the secondary fan means 44 and the compressor 34 are directly connected to AC mains.

It remains to be pointed out that the housing 18 can be mounted entirely on the inside of the enclosure element 12 of the closed technical cabinet, as shown in Fig. 1 to 3, or alternatively, mounted "half in, half out", i.e. with the front side 20 protruding from the front face of the enclosure element 12, but the inside air inlet opening 50 and the supply air outlet opening 43 still lying within the closed technical cabinet, which requires less place within the cabinet. Furthermore, in a less preferred embodiment, the housing 18 is made slightly higher, and the inside air inlet opening 50 and the supply air outlet opening 43 are both integrated in the rear side 22 of the housing 18. This embodiment can then be mounted entirely on the outside of the enclosure element 12 of the closed technical cabinet.

Finally, it will be appreciated that the overall dimensions of the housing 18, can be substantially of the same size as those of a housing of a compact mechanical air-cooling unit exclusively allowing mechanical cooling in a closed loop with air from the inside of the closed technical cabinet.

## Claims

1. A compact air-cooling device for a closed technical cabinet containing heat generating equipment necessitating closely controlled temperature conditions, said air-cooling device comprising:
a housing (18);
a mechanical refrigeration unit including an evaporator (30) and a condenser (32) mounted in said housing (18);
primary fan means (42) and secondary fan means (44) mounted in said housing (18) for circulating air through said evaporator (30) and said condenser (32); and
partition elements (36, 56, 58, 60) mounted in said housing (18) for defining therein a primary air circuit and a secondary air circuit, wherein:
said primary air circuit is designed so that said primary fan means (42) takes in air through an inside air intake chamber (52), which is in direct communication with the inside (14) of said closed technical cabinet, sucks it through said evaporator (30) and blows it back into the inside (14) of said closed technical cabinet, so as to provide a mechanical cooling in a closed loop with air from the inside (14) of said closed technical cabinet;
said secondary air circuit is designed so that said secondary fan means (44) takes in air from the outside environment (16) of said closed technical cabinet and blows it through said condenser (32) back into the outside environment (16) of said closed technical cabinet, so as to cool said condenser (32);
**characterized in that** said partition elements (36, 56, 58, 60) include movable elements (58, 60) which can be brought into an auxiliary position, so that said secondary air circuit is in communication with said primary air circuit upstream of said evaporator (30), and said inside air intake chamber (52) is sealed off from said primary air circuit and is in direct communication with said outside environment of said closed technical cabinet.

2. The device as claimed in claim 1, wherein:
said housing (18) has a front side (20), a rear side (22), an upper side (24),
a lower side and two lateral sides and is designed to be mounted on or in an enclosure element (12) of said closed technical cabinet, so that its front side (20) is in direct communication with the outside environment (16) of said closed technical cabinet.

3. The device as claimed in claim 2, wherein:
said condenser (32) is mounted in an opening in said front side (20) so that its upper edge is located close to said upper side (24) of said housing (18);
said evaporator (30) is mounted obliquely in said housing (18), wherein its lower edge is located substantially in the middle of said housing (18) and its upper edge is located in a corner of said housing (18) where said rear side (22) joins said upper side (24); and
said partition elements (36, 56, 58, 60) include a fixed partition wall (36) extending from said lower edge of said evaporator (30) to said upper edge of said condenser (32), so as to separate a condenser (32) inlet chamber from an evaporator (30) outlet chamber.

4. The device as claimed in any one of claims 1 to 3, wherein:
said primary fan means (42) comprises at least one axial fan.

5. The device as claimed in claim 4, wherein:
said housing (18) includes an upper side (24) in direct communication with the inside of said closed technical cabinet; and
said at least one axial fan (42) is mounted in an opening of said upper side (24) of said housing (18).

6. The device as claimed in any one of claims 1 to 5, wherein:
said housing (18) includes a front side (20) in direct communication with the outside environment (16) of said closed technical cabinet; and
said secondary fan means (44) comprises at least one radial fan mounted in said housing (18) so as to be able take in air from said outside environment through an air inlet (48) in said front side (20) below said condenser (32).

7. The device as claimed in any one of claims 1 to 6, wherein:
said partition elements (56, 58, 60) define an outside air intake chamber (46) in which said secondary fan means (44) is located and which is in direct communication with said condenser inlet chamber (38).

8. The device as claimed in claim 7, wherein:
said partition elements (56, 58, 60) defining said outside air intake chamber (46) include a damper (58) that is movable between a first position, in which it seals off said outside air intake chamber (46) from said primary air circuit, and a second position, in which it establishes a direct communication between said outside air intake chamber (46) and said primary air circuit upstream of said evaporator (30) and simultaneously seals off said inside air intake chamber (52) from said primary air circuit.

9. The device as claimed in any one of claims 1 to 8, wherein:
said movable partition elements (36, 56, 58, 60) include a damper (60) capable of opening and closing a communication between said inside air i n-take chamber (52) and an inside air outlet opening (54) in said housing (18) that opens into said outside environment (16) of said closed technical cabinet

10. The device as claimed in claim 9, wherein:
said housing (18) includes a front side (20) in direct communication with the outside environment (16) of said closed technical cabinet; and
said inside air outlet opening (54) is arranged in said front side (20) of said housing (18).

11. The device as claimed in any one of claims 1 to 10, wherein:
said movable partition elements (58, 60) include a damper (58) that is capable of sealing off said inside air intake chamber(52) from said primary air circuit.

12. The device as claimed in any one of claims 1 to 11, wherein:
said mechanical refrigeration unit includes a compressor (34) mounted in said inside air intake chamber (52).

13. The device as claimed in any one of claims 1 to 12, further comprising:
control means for said movable partition elements (58, 60), said control means measuring thermodynamic conditions of the outside air and the inside air and setting the position of said movable partition elements (58, 60) in function of said thermodynamic conditions.

14. The device as claimed in claim 13, wherein said control means are capable of setting said movable partition elements (58, 60):
in a first position in which said device provides mechanical cooling in a closed loop of the air from the inside (14) of said closed technical cabinet, if the thermodynamic conditions of the air inside said closed technical cabinet are more favorable than the thermodynamic conditions of the air outside said closed technical cabinet; and
in a second position in which said device provides mechanical cooling in an open loop with air from the outside of said closed technical cabinet, if the thermodynamic conditions of the air outside said closed technical cabinet are more favorable than the thermodynamic conditions of the air inside said closed technical cabinet, wherein air from the inside of said closed technical cabinet is evacuated by overpressure through said inside air intake chamber (52) directly into said outside environment (16) of said closed technical cabinet.

15. The device as claimed in claim 14, wherein said control means are designed so as to:
set said movable partition elements (58, 60) in their second position, and
switch off said mechanical cooling unit and said secondary fan means (44), if the thermodynamic conditions of the outside air allow a free cooling of said closed technical cabinet.

16. The device as claimed in claim 15, wherein:
said device is connected to a main electric supply and to an electric emergency supply;
said control means are designed so as to automatically set said movable partition elements (36, 56, 58, 60) in their second position when said device is to powered by said electric emergency supply; and
electric energy supply of said mechanical cooling unit and said secondary fan means (44) is interrupted, when said device is powered by said electric emergency supply.

17. The device as claimed in claim 15, wherein:
said primary fan means (42) and said control means are powered via a DC power supply with battery back-up; and
said secondary fan means (44) and said mechanical refrigeration unit are directly connected to AC mains.

18. The device as claimed in any one of claims 1 to 17, further comprising:
an air filter (39) mounted in parallel to said evaporator (30).

19. The device as claimed in any one of claims 1 to 18, further comprising:
an electric heating element (62) mounted downstream of said evaporator (30).

20. A closed technical cabinet for containing heat generating equipment, said cabinet comprising a compact air-cooling device (10) as claimed hereinbefore.

21. The closed technical cabinet as claimed in claim 20, including a door element (12), wherein:
said housing (18) of said compact air-cooling device (10) has a front side (20), a rear side (22), an upper side (24), a lower side and two lateral sides; and
said housing (18) is mounted on or in said door element of said closed technical cabinet, so that its front side (20) is in direct communication with the outside environment of said closed technical cabinet, and its upper side (24) is in direct communication with the inside of said closed technical cab i-net.

## Revendications

1. Dispositif de refroidissement à air compact pour une armoire technique fermée contenant un équipement dégageant de la chaleur nécessitant des conditions de température étroitement régulées, ledit dispositif de refroidissement à air comprenant :
un boîtier (18);
une unité frigorifique mécanique comprenant un évaporateur (30) et un condenseur (32) montés dans ledit boîtier (18);
un moyen formant ventilateur primaire (42) et un moyen formant ventilateur secondaire (44) montés dans ledit boîtier (18) pour faire circuler l'air à travers ledit évaporateur (30) et ledit condenseur (32); et
des éléments de séparation (36, 56, 58, 60) montés dans ledit boîtier (18) pour définir en son sein un circuit d'air primaire et un circuit d'air secondaire, dans lequel:
ledit circuit d'air primaire est conçu de sorte que ledit moyen formant ventilateur primaire (42) prélève de l'air à travers une chambre d'admission d'air intérieur (52), qui est en communication directe avec l'intérieur (14) de ladite armoire technique fermée, l'aspire à travers ledit évaporateur (30) et le ressouffle dans l'intérieur (14) de ladite armoire technique fermée, de façon à créer un refroidissement mécanique en boucle fermée avec de l'air en provenance de l'intérieur (14) de ladite armoire technique fermée;
ledit circuit d'air secondaire est conçu de sorte que ledit moyen formant ventilateur secondaire (44) prélève de l'air de l'environnement extérieur (16) de ladite armoire technique fermée, et le ressouffle à travers ledit condenseur (32) dans l'environnement extérieur (16) de ladite armoire technique fermée, de façon à refroidir ledit condenseur (32);
**caractérisé en ce que** lesdits éléments de séparation (36, 56, 58, 60) comprennent des éléments mobiles (58, 60) qui peuvent être amenés dans une position auxiliaire, de sorte que ledit circuit d'air secondaire est en communication avec ledit circuit d'air primaire en amont dudit évaporateur (30), et ladite chambre d'admission d'air intérieur (52) est hermétiquement fermée par rapport audit circuit d'air primaire et est en communication directe avec ledit environnement extérieur de ladite armoire technique fermée.

2. Dispositif selon la revendication 1, dans lequel :
ledit boîtier (18) a un côté avant (20), un côté arrière (22), un côté supérieur (24), un côté inférieur et deux côtés latéraux et est conçu pour être monté sur ou dans un élément d'enceinte (12) de ladite armoire technique fermée, de sorte que son côté avant (20) est en communication directe avec l'environnement extérieur (16) de ladite armoire technique fermée.

3. Dispositif selon la revendication 2, dans lequel :
ledit condenseur (32) est monté dans une ouverture dans ledit côté avant (20) de sorte que son bord supérieur est situé près dudit bord supérieur (24) dudit boîtier (18);
ledit évaporateur (30) est monté en biais dans ledit boîtier (18), où son bord inférieur est situé substantiellement au milieu dudit boîtier (18) et son bord supérieur est situé dans un coin dudit boîtier (18) où ledit côté arrière (22) rejoint ledit côté supérieur (24); et
lesdits éléments de séparation (36, 56, 58, 60) comprennent une paroi de séparation fixe (36) s'étendant dudit bord inférieur dudit évaporateur (30) audit bord supérieur dudit condenseur (32), de façon à séparer une chambre d'entrée du condenseur (32) d'une chambre de sortie de l'évaporateur (30).

4. Dispositif selon l'une quelconque des revendications 1 à 3, dans lequel :
ledit moyen formant ventilateur primaire (42) comprend au moins un ventilateur axial.

5. Dispositif selon la revendication 4, dans lequel :
ledit boîtier (18) comprend un côté supérieur (24) en communication directe avec l'intérieur de ladite armoire technique fermée; et
ledit au moins un ventilateur axial (42) est monté dans une ouverture dudit côté supérieur (24) dudit boîtier (18).

6. Dispositif selon l'une quelconque des revendications 1 à 5, dans lequel :
ledit boîtier (18) comprend un côté avant (20) en communication directe avec l'environnement extérieur (16) de ladite armoire technique fermée; et
ledit moyen formant ventilateur secondaire (44) comprend au moins un ventilateur radial monté dans ledit boîtier (18) de façon à pouvoir prélever de l'air dudit environnement extérieur à travers une entrée d'air (48) dans ledit côté avant (20) au-dessous dudit condenseur (32).

7. Dispositif selon l'une quelconque des revendications 1 à 6, dans lequel :
lesdits éléments de séparation (56, 58, 60) définissent une chambre d'admission d'air extérieur (46) dans laquelle ledit moyen formant ventilateur secondaire (44) est situé et qui est en communication directe avec ladite chambre d'entrée de condenseur (38).

8. Dispositif selon la revendication 7, dans lequel :
lesdits éléments de séparation (56, 58, 60) définissant ladite chambre d'admission d'air extérieur (46) comprennent un registre (58) qui est mobile entre une première position, dans laquelle il ferme hermétiquement ladite chambre d'admission d'air extérieur (46) et l'isole dudit circuit d'air primaire, et une deuxième position, dans laquelle il établit une communication directe entre ladite chambre d'admission d'air extérieur (46) et ledit circuit d'air primaire en amont dudit évaporateur (30) et ferme simultanément hermétiquement ladite chambre d'admission d'air intérieur (52) pour l'isoler dudit circuit d'air primaire.

9. Dispositif selon l'une quelconque des revendications 1 à 8, dans lequel:
lesdits éléments de séparation mobiles (36, 56, 58, 60) comprennent un registre (60) capable d'ouvrir et de fermer une communication entre ladite chambre d'admission d'air intérieur (52) et une ouverture de sortie d'air intérieur (54) dans ledit boîtier (18) qui s'ouvre dans ledit environnement extérieur (16) de ladite armoire technique fermée.

10. Dispositif selon la revendication 9, dans lequel :
ledit boîtier (18) comprend un côté avant (20) en communication directe avec l'environnement extérieur (16) de ladite armoire technique fermée; et
ladite ouverture de sortie d'air intérieur (54) est disposée dans ledit côté avant (20) dudit boîtier (18).

11. Dispositif selon l'une quelconque des revendications 1 à 10, dans lequel :
lesdits éléments de séparation mobiles (58, 60) comprennent un registre (58) qui est capable de fermer hermétiquement ladite chambre d'admission d'air intérieur (52) et de l'isoler dudit circuit d'air primaire.

12. Dispositif selon l'une quelconque des revendications 1 à 11, dans lequel:
ladite unité frigorifique mécanique comprend un compresseur (34) monté dans ladite chambre d'admission d'air intérieur (52).

13. Dispositif selon l'une quelconque des revendications 1 à 12, comprenant en outre :
un moyen de commande pour lesdits éléments de séparation mobiles (58, 60), ledit moyen de commande mesurant les conditions thermodynamiques de l'air extérieur et de l'air intérieur et réglant la position desdits éléments de séparation mobiles (58, 60) en fonction desdites conditions thermodynamiques.

14. Dispositif selon la revendication 13, dans lequel ledit moyen de commande est capable de régler lesdits éléments de séparation mobiles (58, 60) :
dans une première position dans laquelle ledit dispositif assure le refroidissement mécanique en boucle fermée de l'air à partir de l'intérieur (14) de ladite armoire technique fermée, si les conditions thermodynamiques de l'air à l'intérieur de ladite armoire technique fermée sont plus favorables que les conditions thermodynamiques de l'air à l'extérieur de ladite armoire technique fermée; et
dans une deuxième position dans laquelle ledit dispositif assure le refroidissement mécanique en boucle ouverte avec l'air en provenance de l'extérieur de ladite armoire technique fermée, si les conditions thermodynamiques de l'air à l'extérieur de ladite armoire technique fermée sont plus favorables que les conditions thermodynamiques de l'air à l'intérieur de ladite armoire technique fermée, où l'air en provenance de l'intérieur de ladite armoire technique fermée étant évacué par surpression à travers ladite chambre d'admission d'air intérieur (52) directement dans ledit environnement extérieur (16) de ladite armoire technique fermée.

15. Dispositif selon la revendication 14, dans lequel ledit moyen de commande est conçu de façon à :
régler lesdits éléments de séparation mobiles (58, 60) dans leur deuxième position, et
éteindre ladite unité de refroidissement mécanique et ledit moyen formant ventilateur secondaire (44), si les conditions thermodynamiques de l'air extérieur permettent un refroidissement libre de ladite armoire technique fermée.

16. Dispositif selon la revendication 15, dans lequel :
ledit dispositif est relié à une alimentation électrique principale et à une alimentation électrique d'urgence;
ledit moyen de commande est conçu de façon à régler automatiquement lesdits éléments de séparation mobiles (36, 56, 58, 60) dans leur deuxième position lorsque ledit dispositif est alimenté par ladite alimentation électrique d'urgence; et
l'alimentation en énergie électrique de ladite unité de refroidissement mécanique et dudit moyen formant ventilateur secondaire (44) est interrompue lorsque ledit dispositif est alimenté par ladite alimentation électrique d'urgence.

17. Dispositif selon la revendication 15, dans lequel :
ledit moyen formant ventilateur primaire (42) et ledit moyen de commande sont alimentés en énergie par une alimentation en énergie CC à l'aide d'une batterie de secours; et
ledit moyen formant ventilateur secondaire (44) et ladite unité frigorifique mécanique sont reliés directement au secteur CA.

18. Dispositif selon l'une quelconque des revendications 1 à 17, comprenant en outre :
un filtre à air (39) monté en parallèle audit évaporateur (30).

19. Dispositif selon l'une quelconque des revendications 1 à 18, comprenant en outre :
un élément de chauffage électrique (62) monté en aval dudit évaporateur (30).

20. Armoire technique fermée pour contenir un équipement dégageant de la chaleur, ladite armoire comprenant un dispositif de refroidissement à air compact (10) selon les revendications ci-dessus.

21. Armoire technique fermée selon la revendication 20, comprenant un élément de porte (12), dans laquelle :
ledit boîtier (18) dudit dispositif de refroidissement à air compact (10) comporte un côté avant (20), un côté arrière (22), un côté supérieur (24), un côté inférieur et deux côtés latéraux; et
ledit boîtier (18) est monté sur ou dans ledit élément de porte de ladite armoire technique fermée, de sorte que son côté avant (20) est en communication directe avec l'environnement extérieur de ladite armoire technique fermée, et son côté supérieur (24) est en communication directe avec l'intérieur de ladite armoire technique fermée.

## Patentansprüche

1. Kompaktklimagerät für einen geschlossenen Schaltschrank, der eine Wärme erzeugende Einrichtung enthält, die eng geregelte Temperaturbedingungen erfordert, wobei das Klimagerät umfasst:
ein Gehäuse (18);
eine mechanische Kühleinheit, die einen Verdampfer (30) und einen Kondensator (32) umfasst, die im Gehäuse (18) eingebaut sind;
ein Primärlüftermittel (42) und ein Sekundärlüftermittel (44), die im Gehäuse (18) eingebaut sind, um Luft durch den Verdampfer (30) und den Kondensator (32) zirkulieren zu lassen; und
Trennelemente (36, 56, 58, 60), die im Gehäuse (18) eingebaut sind, um darin einen Primärluftkreislauf und einen Sekundärluftkreislauf zu definieren, wobei:
der Primärluftkreislauf so ausgelegt ist, dass das Primärlüftermittel (42) Luft durch eine Innenlufteinlasskammer (52) hereinzieht, die in direkter Verbindung mit dem Innenraum (14) des geschlossenen Schaltschranks steht, durch den Verdampfer (30) saugt und in den Innenraum (14) des geschlossenen Schaltschranks zurückbläst, um so eine mechanische Kühlung in einem geschlossenen Kreislauf mit Luft vom Innenraum (14) des geschlossenen Schaltschranks zu bewirken;
der Sekundärluftkreislauf so ausgelegt ist, dass das Sekundärlüftermittel (44) Luft von der äußeren Umgebung (16) des geschlossenen Schaltschranks hereinzieht und durch den Kondensator (32) in die äußere Umgebung (16) des geschlossenen Schaltschranks zurückbläst, um so den Kondensator (32) zu kühlen;
**dadurch gekennzeichnet, dass**
die Trennelemente (36, 56, 58, 60) bewegliche Elemente (58, 60) umfassen, die so in eine zusätzliche Position gebracht werden können, dass der Sekundärluftkreislauf in Strömungsrichtung vor dem Verdampfer (30) mit dem Primärluftkreislauf in Verbindung steht und die Innenlufteinlasskammer (52) gegen den Primärtuftkreistauf abgedichtet ist und in direkter Verbindung mit der äußeren Umgebung des geschlossenen Schaltschranks steht.

2. Gerät nach Anspruch 1, wobei:
das Gehäuse (18) eine Vorderseite (20), eine Rückseite (22), eine Oberseite (24), eine Unterseite und zwei seitliche Seiten aufweist und derart konstruiert ist, dass es so an oder in einem umschließenden Element (12) des geschlossenen Schaltschranks zu befestigen ist, dass seine Vorderseite (20) in direkter Verbindung mit der äußeren Umgebung (16) des geschlossenen Schaltschranks steht.

3. Gerät nach Anspruch 2, wobei:
der Kondensator (32) so in einer Öffnung in der Vorderseite (20) eingebaut ist, dass seine Oberkante nahe der Oberseite (24) des Gehäuses (18) angeordnet ist;
der Verdampfer (30) schräg im Gehäuse (18) eingebaut ist, wobei seine Unterkante im Wesentlichen in der Mitte des Gehäuses (18) angeordnet ist und seine Oberkante in einer Ecke des Gehäuses (18) angeordnet ist, wo die Rückseite (22) und die Oberseite (24) miteinander verbunden sind; und die Trennelemente (36, 56, 58, 60) eine feste Trennwand (36) umfassen, die von der Unterkante des Verdampfers (30) zur Oberkante des Kondensators (32) verläuft, um so eine Einlasskammer des Kondensators (32) von einer Auslasskammer des Verdampfers (30) zu trennen.

4. Gerät nach irgendeinem der Ansprüche 1 bis 3, wobei:
das Primärlüftermittel (42) mindestens einen Axiallüfter umfasst.

5. Gerät nach Anspruch 4, wobei:
das Gehäuse (18) eine Oberseite (24) in direkter Verbindung mit dem Innenraum des geschlossenen Schaltschranks umfasst; und
der mindestens eine Axiallüfter (42) in einer Öffnung der Oberseite (24) des Gehäuses (18) befestigt ist.

6. Gerät nach irgendeinem der Ansprüche 1 bis 5, wobei:
das Gehäuse (18) eine Vorderseite (20) in direkter Verbindung mit der äußeren Umgebung (16) des geschlossenen Schaltschranks umfasst; und das Sekundärlüftermittel (44) mindestens einen Radiaflüfter umfasst, der im Gehäuse (18) eingebaut ist, um so Luft von der äußeren Umgebung durch einen Lufteinlass (48) in der Vorderseite (20) unter dem Kondensator (32) hereinziehen zu können.

7. Gerät nach irgendeinem der Ansprüche 1 bis 6, wobei:
die Trennelemente (56, 58, 60) eine Außenlufteinlasskammer (46) definieren, in der das Sekundärlüftermittel (44) angeordnet ist und die in direkter Verbindung mit der Kondensatoreinlasskammer (38) steht.

8. Gerät nach Anspruch 7, wobei:
die Trennelemente (56, 58, 60), die die Außenlufteinlasskammer (46) definieren, eine Klappe (58) umfassen, die zwischen einer ersten Position, in der sie die Außenlufteinlasskammer (46) gegen den Primärtuftkreislauf abdichtet, und einer zweiten Position beweglich ist, in der sie in Strömungsrichtung vor dem Verdampfer (30) eine direkte Verbindung zwischen der Außenlufteinlasskammer (46) und dem Primärluftkreislauf herstellt und zugleich die Innenlufteinlasskammer (52) gegen den Primärluftkreislauf abdichtet.

9. Gerät nach irgendeinem der Ansprüche 1 bis 8, wobei:
die beweglichen Trennelemente (36, 56, 58, 60) eine Klappe (60) umfassen, die eine Verbindung zwischen der lnnenlufteinlasskammer (52) und einer Innenluftauslassöffnung (54) im Gehäuse (18) öffnen und schließen kann, die zur äußeren Umgebung (16) des geschlossenen Schaltschranks hin öffnet.

10. Gerät nach Anspruch 9, wobei:
das Gehäuse (18) eine Vorderseite (20) in direkter Verbindung mit der äußeren Umgebung (16) des geschlossenen Schaltschranks umfasst; und die Innenluftauslassöffnung (54) in der Vorderseite (20) des Gehäuses (18) angeordnet ist.

11. Gerät nach irgendeinem der Ansprüche 1 bis 10, wobei:
die beweglichen Trennelemente (58, 60) eine Klappe (58) umfassen, die die Innenlufteinlasskammer (52) gegen den Primärluftkreislauf abdichten kann.

12. Gerät nach irgendeinem der Ansprüche 1 bis 11, wobei:
die mechanische Kühleinheit einen Kompressor (34) umfasst, der in der Innenlufteihlasskammer (52) eingebaut ist.

13. Gerät nach irgendeinem der Ansprüche 1 bis 12, ferner umfassend:
ein Steuermittel für die beweglichen Trennelemente (58, 60), wobei das Steuermittel thermodynamische Bedingungen der Außenluft und der Innenluft misst und die Position der beweglichen Trennelemente (58, 60) in Abhängigkeit von den thermodynamischen Bedingungen einstellt.

14. Gerät nach Anspruch 13, wobei das Steuermittel die beweglichen Trennelemente (58, 60) stellen kann:
in eine erste Position, in der das Gerät eine mechanische Kühlung in einem geschlossen Kreislauf der Luft vom Innenraum (14) des geschlossenen Schaltschranks bereitstellt, wenn die thermodynamischen Bedingungen der Luft im geschlossenen Schaltschrank günstiger sind als die thermodynamischen Bedingungen der Luft außerhalb des geschlossenen Schaltschranks; und
in eine zweite Position, in der das Gerät eine mechanische Kühlung in einem offenen Kreislauf der Luft von der Außenseite des geschlossenen Schaltschranks bereitstellt, wenn die thermodynamischen Bedingungen der Luft außerhalb des geschlossenen Schaltschranks günstiger sind als die thermodynamischen Bedingungen der Luft im geschlossenen Schaltschrank, wobei Luft vom Innenraum des geschlossenen Schaltschranks mittels Überdruck durch die Innenlufteinlasskammer (52) direkt in die äußere Umgebung (16) des geschlossenen Schaltschranks herausgelassen wird.

15. Gerät nach Anspruch 14, wobei das Steuermittel so konstruiert ist, dass es:
die beweglichen Trennelemente (58, 60) in ihre zweite Position stellt und die mechanische Kühleinheit und das Sekundärlüftermittel (44) ausschaltet, wenn die thermodynamischen Bedingungen der Außenluft eine freie Kühlung des geschlossenen Schaltschranks erlauben.

16. Gerät nach Anspruch 15, wobei:
das Gerät an eine Hauptstromversorgung und eine Notstromversorgung angeschlossen ist;
das Steuermittel so konstruiert ist, dass es automatisch die beweglichen Trennelemente (36, 56, 58, 60) in ihre zweite Position stellt, wenn das Gerät durch die Notstromversorgung zu speisen ist; und
die Stromversorgung der mechanischen Kühleinheit und des Sekundärlüftermittels (44) unterbrochen wird, wenn das Gerät durch die Notstromversorgung gespeist wird.

17. Gerät nach Anspruch 15, wobei:
das Primärlüftermittel (42) und das Steuermittel über eine Gleichstromversorgung mit Batteriepufferung gespeist werden; und
das Sekundärlüftermittel (44) und die mechanische Kühleinheit direkt an ein Wechselstromnetz angeschlossen sind.

18. Gerät nach irgendeinem der Ansprüche 1 bis 17, ferner umfassend:
einen Luftfilter (39), der parallel zum Verdampfer (30) befestigt ist.

19. Gerät nach irgendeinem der Ansprüche 1 bis 18, ferner umfassend:
ein elektrisches Heizelement (62), das in Strömungsrichtung hinter dem Verdampfer (30) befestigt ist.

20. Geschlossener Schaltschrank zur Aufnahme einer Wärme erzeugenden Einrichtung, wobei der Schrank ein Kompaktklimagerät (10) nach den vorstehenden Ansprüchen umfasst.

21. Geschlossener Schaltschrank nach Anspruch 20, umfassend ein Türelement (12), wobei:
das Gehäuse (18) des Kompaktklimageräts (10) eine Vorderseite (20), eine Rückseite (22), eine Oberseite (24), eine Unterseite und zwei seitliche Seiten aufweist; und
das Gehäuse (18) so an oder in dem Türelement des geschlossenen Schaltschranks befestigt ist, dass seine Vorderseite (20) in direkter Verbindung mit der äußeren Umgebung des geschlossenen Schaltschranks steht und seine Oberseite (24) in direkter Verbindung mit dem Innenraum des geschlossenen Schaltschranks steht.
